# EUROPEAN PATENT APPLICATION

(11) **EP 1 983 605 A1**
(43) Date of publication of application: **22.10.2008**
(21) Application number: 08006400.9
(22) Date of filing: 31.03.2008
(51) Int. Cl.: H01Q 1/22, H01Q 1/36

(54) **Antenna device**

(30) Priority: 16.04.2007 JP 2007107075
(71) Applicant: Alps Electric Co., Ltd., Ota-ku Tokyo 145-8501 (JP)
(72) Inventor: Ohtaki, Yukio, Tokyo, 145-8501 (JP); Takayama, Akira, Tokyo, 145-8501 (JP)
(74) Representative: Klunker . Schmitt-Nilson . Hirsch

(57) **Abstract**

An antenna device for television broadcast reception includes an antenna element including a base member (2) and a radiating conductor (3), and a matching circuit. A feed signal is supplied to the antenna element via the matching circuit. The matching circuit includes a variable capacitance element (4) (varactor diode), a first inductance element (5) connected in parallel to the variable capacitance element, and a second inductance element (6) connected in series with the variable capacitance element. A capacitance value of the variable capacitance element is changed to change a resonant frequency of the antenna element. The variable capacitance element and the first inductance element form a parallel circuit, and a resonance point of the parallel circuit is set to a frequency lower than the resonant frequency of the antenna element. As the resonant frequency increases, the resonance point is shifted to a high-frequency side.

## Description

### CLAIM OF PRIORITY

This application claims benefit of the Japanese Patent Application No. 2007-107075 filed on April 16, 2007, which is hereby incorporated by reference.

### BACKGROUND OF THE INVENTION

### 1. Field of the Invention

The present invention relates to an antenna device having a matching circuit connected to a radiating conductor. More specifically, the present invention relates to an antenna device for television broadcast reception, the antenna device including a variable capacitance element and being capable of resonating with radio waves of different frequency bands.

### 2. Description of the Related Art

Recently, compact antenna devices for terrestrial digital television broadcast reception have become widespread. In the related art, this type of antenna device is configured such that a radiating conductor is patterned on a surface of a base member such as a dielectric base member to reduce the size of the antenna device and such that the radiating conductor is connected to a plurality of variable capacitance elements to change a tuning frequency (see, for example, Japanese Unexamined Patent Application Publication No. 2003-298341 (pages 2 to 3, Fig. 1)). As the variable capacitance elements, varactor diodes (varicap diodes) are generally used. The varactor diodes have a characteristic that the capacitance value of the varactor diodes decreases as a reverse voltage (tuning voltage based on a bias control signal) applied thereto increases. Thus, as the reverse voltage is increased so as to reduce the capacitance value of the varactor diodes connected in series with the radiating conductor, the resonant frequency of the radiating conductor increases.

This type of antenna device is mounted on a circuit board, and a feed signal is supplied to a feed portion of the radiating conductor via a transmission line from a feed circuit on the circuit board. To achieve a practical antenna device with low loss, an input impedance of the radiating conductor is matched to a characteristic impedance of the feed circuit, and a matching circuit is generally provided in the transmission line. The matching circuit typically includes an inductance element and a capacitance element. In some matching circuits, a varactor diode is used as a capacitance element.

As described above, an existing antenna device for television broadcast reception is configured such that a plurality of variable capacitance elements are connected to change a resonant frequency of a radiating conductor. In such an antenna device, a plurality of variable capacitance elements are provided to achieve desired tuning and matching. However, the variable capacitance elements, such as varactor diodes, are costly, and suffer from a problem in that a number of variable capacitance elements increase the cost of parts and increase the manufacturing cost of the antenna device.

### SUMMARY OF THE INVENTION

The present invention provides a low-cost antenna device for television broadcast reception in which a reduced number of variable capacitance elements are used to reduce the cost of parts.

According to an aspect of the present invention, an antenna device includes an antenna element, and a matching circuit. A feed signal is supplied to the antenna element via the matching circuit. The matching circuit includes a variable capacitance element, a first inductance element connected in parallel to the variable capacitance element, and a second inductance element connected in series with the variable capacitance element. A capacitance value of the variable capacitance element is changed to change a resonant frequency of the antenna element. The variable capacitance element and the first inductance element form a parallel circuit, and a resonance point of the parallel circuit is set to a frequency lower than the resonant frequency. As the resonant frequency increases, the resonance point is shifted to a high-frequency side.

Accordingly, the matching circuit includes a parallel circuit formed of the variable capacitance element and the first inductance element, and the capacitance value of the variable capacitance element is changed to change the resonant frequency of the antenna element. By reducing the capacitance value to increase a tuning frequency, the capacitive reactance of the variable capacitance element increases, and the resonance point of the parallel circuit is shifted to a high-frequency side. Further, the matching circuit is configured such that the reactance of the parallel circuit can cancel an inductive reactance, which is the sum of the inductive reactance of the second inductance element and the capacitive reactance of the antenna element. The value of the inductive reactance, which is the sum of the inductive reactance of the second inductance element and the capacitive reactance of the antenna element, and the value of the capacitive reactance of the parallel circuit change in a similar manner within a predetermined frequency range. Therefore, even if the matching circuit includes a single variable capacitance element, the tuning of the antenna element and the impedance matching can be achieved using the single variable capacitance element. Thus, the cost of parts can be reduced. Therefore, a low-cost antenna device for television broadcast reception can be achieved.

Preferably, the antenna element includes a dielectric or magnetic base member, and a radiating conductor provided on a surface of the base member. The variable capacitance element of the matching circuit may be a varactor diode, and a tuning voltage may be applied to the variable capacitance element via a transmission line transmitting a high-frequency signal. Thus, wiring can be simplified.

The antenna device may receive a terrestrial digital television broadcast signal wave. Therefore, a low-cost, high-practicability antenna device for television broadcast reception can be achieved.

The base member may be cylindrical, and the matching circuit and the radiating conductor may be provided on the surface of the base member so that the radiating conductor is spirally wound around the surface of the base member. Further, the radiating conductor may have a first end which serves as a feed portion, and a second end which is an open end. Thus, a compact chip antenna device which can easily be mounted on a circuit board and which is capable of receiving radio waves of an ultra-high frequency (UHF) band can be achieved. Therefore, an antenna device for television broadcast reception, which is suitable as a built-in antenna of a mobile phone or the like, can be achieved.

### BRIEF DESCRIPTION OF THE DRAWINGS

Fig. 1 is a perspective view of an antenna device according to an exemplary embodiment of the present invention;
Fig. 2 is an equivalent circuit diagram of the antenna device;
Fig. 3 is a diagram showing a state in which the antenna device is mounted;
Fig. 4 is a reactance characteristic diagram of the antenna device; and
Fig. 5 is a reactance characteristic diagram of an LC parallel circuit included in a matching circuit of the antenna device.

### DESCRIPTION OF THE PREFERRED EMBODIMENTS

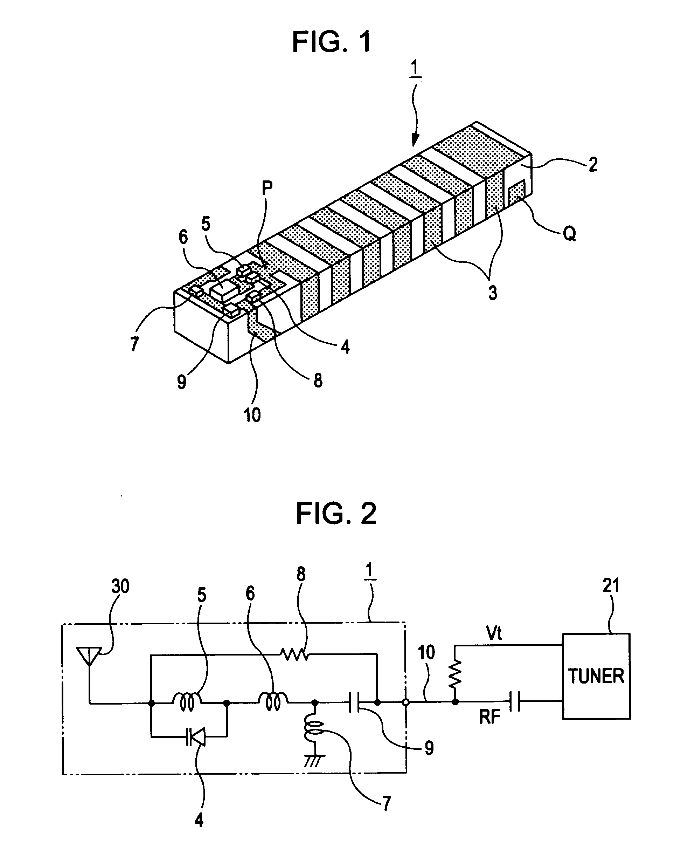

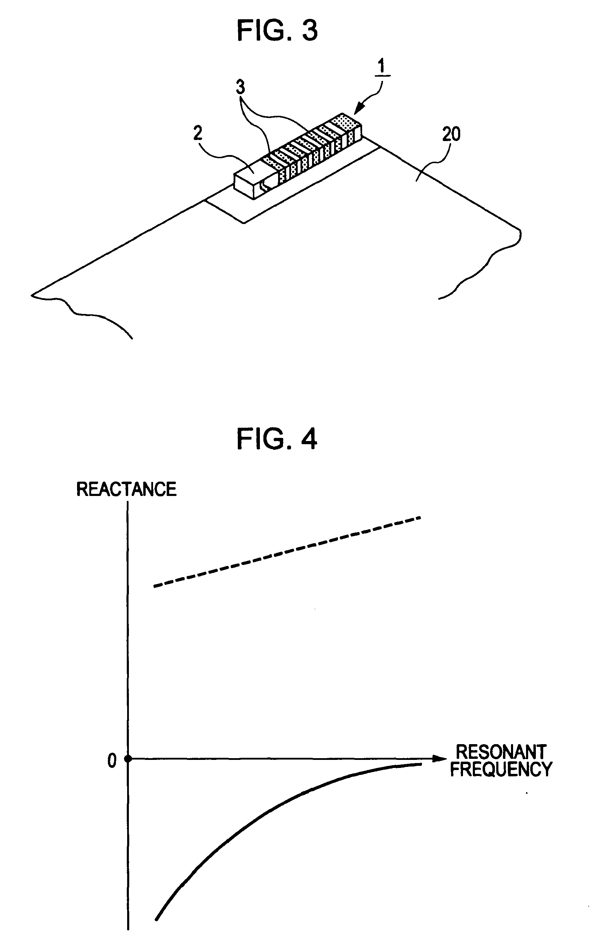

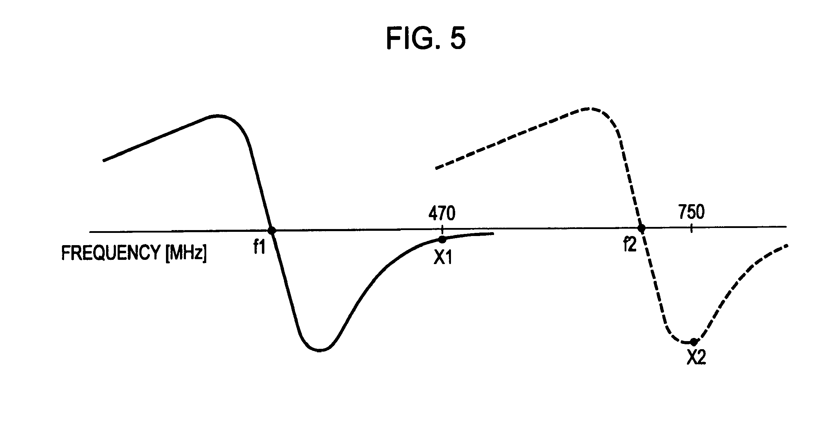

An embodiment of the present invention will be described with reference to the drawings. Fig. 1 is a perspective view of an antenna device according to an exemplary embodiment of the present invention, and Fig. 2 is an equivalent circuit diagram of the antenna device. Fig. 3 is a diagram showing a state in which the antenna device is mounted. Fig. 4 is a reactance characteristic diagram of the antenna device, and Fig. 5 is a reactance characteristic diagram of an inductor-capacitor (LC) parallel circuit included in a matching circuit of the antenna device.

Referring to Figs. 1 to 3, an antenna device 1 is a chip antenna mounted on a circuit board 20 (see Fig. 3) along an edge thereof, the circuit board 20 being provided in a mobile phone. The antenna device 1 is used as an antenna for terrestrial digital television broadcast reception. Terrestrial digital television broadcasts are transmitted using signal waves in a frequency band of 470 MHz to 750 MHz.

The antenna device 1 mainly includes a cylindrical dielectric (or magnetic) base member 2, a radiating conductor 3 having a spiral conductor pattern wound around a surface of the base member 2, and electronic elements 4 to 9 located at an end portion of an upper surface of the base member 2. The base member 2 and the radiating conductor 3 form an antenna element 30. An end of the spirally extending radiating conductor 3 serves as a feed portion P and the other end thereof is an open end Q. The electronic elements 4 to 9 are a variable capacitance element 4, inductance elements 5 to 7, a resistance element 8, and a capacitor 9. The variable capacitance element 4 is a varactor diode (varicap diode), and is connected in parallel to the inductance element 5. The inductance element 6 is connected in series with the variable capacitance element 4, and the inductance element 7 is connected between the inductance element 6 and a ground (ground line). The resistance element 8 is connected to a cathode of the variable capacitance element 4. The variable capacitance element 4 and the inductance elements 5 to 7 form a matching circuit for matching an input impedance to a characteristic impedance. The matching circuit is connected in series with the feed portion P of the radiating conductor 3, and is also connected to a transmission line 10 transmitting a high-frequency signal (RF signal) via the capacitor 9. The resistance element 8 is also connected to the transmission line 10 in parallel to the capacitor 9. A tuning voltage Vt, which is a reverse voltage, is applied to the variable capacitance element 4 via the resistance element 8 to change a resonant frequency of the antenna element 30.

The transmission line 10 of the antenna device 1 is patterned on a side surface of the base member 2, and a lower end of the transmission line 10 is connected to a television tuner circuit 21 provided on the circuit board 20 via a transmission line (not shown). A bias circuit (not shown) is also provided on the circuit board 20. A pulse width modulation (PWM) signal serving as a bias control signal or a power supply voltage is input to the bias circuit to generate the tuning voltage Vt. As shown in Fig. 2, the tuning voltage Vt is applied to the variable capacitance element 4 via the transmission line 10. As the tuning voltage Vt increases, the capacitance value of the variable capacitance element 4 decreases and the resonant frequency of the antenna element 30 increases. As the tuning voltage Vt decreases, the capacitance value of the variable capacitance element 4 increases and the resonant frequency decreases. The circuit board 20 has a ground pattern (not shown) formed thereon at least in the vicinity of the antenna device 1.

As indicated by a solid line in Fig. 4, the reactance of the antenna element 30 (radiating conductor 3) of the antenna device 1 is capacitive. As the frequency increases, the capacitive reactance approaches zero. A curve indicated by a broken line in Fig. 4 indicates an inductive reactance of the inductance element 6 of the matching circuit. An inductive reactance Xa, which is the sum of the inductive reactance of the inductance element 6 and the capacitive reactance of the antenna element 30, increases in accordance with an increase in the tuning frequency. To achieve impedance matching, the inductive reactance Xa is canceled by a capacitive reactance Xb of an LC parallel circuit formed of the variable capacitance element 4 and the inductance element 5.

A curve indicated by a solid line in Fig. 5 indicates a reactance characteristic of the LC parallel circuit, which is obtained when the capacitance value of the variable capacitance element 4 is increased (the tuning voltage Vt is reduced) so that the tuning frequency becomes 470 MHz. The reactance is inductive in a frequency range lower than a resonance point f1, and is capacitive in a frequency range higher than the resonance point f1. At a frequency of 470 MHz, the reactance Xb of the LC parallel circuit is capacitive and has a small value (X1). A curve indicated by a broken line in Fig. 5 indicates a reactance characteristic of the LC parallel circuit, which is obtained when the capacitance value of the variable capacitance element 4 is reduced (the tuning voltage Vt is increased) so that the tuning frequency becomes 750 MHz. The reactance is inductive in a frequency range lower than a resonance point f2, and is capacitive in a frequency range higher than the resonance point f2. That is, as the tuning frequency increases from 470 MHz to 750 MHz, the resonance point of the LC parallel circuit is shifted to the high-frequency side. At a frequency of 750 MHz, the reactance Xb of the LC parallel circuit is capacitive and has a relatively large value (X2). In the frequency range of 470 MHz to 750 MHz, the resonance point of the LC parallel circuit is always lower than the tuning frequency. Accordingly, the tuning voltage Vt to be applied to the variable capacitance element 4 is controlled to change the resonant frequency of the antenna element 30 within a range of 470 MHz to 750 MHz, whereby the value of the capacitive reactance Xb of the LC parallel circuit changes in a manner similar to the value of the inductive reactance Xa, which is the sum of the inductive reactance of the inductance element 6 and the capacitive reactance of the antenna element 30. Therefore, the inductive reactance Xa can be canceled by the capacitive reactance Xb of the LC parallel circuit, thereby achieving impedance matching.

Accordingly, the antenna device 1 of the exemplary embodiment is provided with a matching circuit including an LC parallel circuit formed of the variable capacitance element 4 and the inductance element 5. The capacitance value of the variable capacitance element 4 is changed to change the resonant frequency of the antenna element 30. As the capacitance value of the variable capacitance element 4 is reduced to increase the tuning frequency, the capacitive reactance of the variable capacitance element 4 increases. Thus, the resonance point of the LC parallel circuit is shifted to the high-frequency side. Further, the value of the capacitive reactance Xb of the LC parallel circuit within a predetermined frequency range (470 MHz to 750 MHz) changes in a manner similar to the value of the inductive reactance Xa, which is the sum of the inductive reactance of the inductance element 6 and the capacitive reactance of the antenna element 30. Thus, the inductive reactance Xa can be canceled by the capacitive reactance Xb of the LC parallel circuit, thereby achieving impedance matching. In the antenna device 1 for television broadcast reception, therefore, even if the matching circuit includes a single variable capacitance element, the tuning of the antenna element 30 and the impedance matching can be achieved using the single variable capacitance element, and the cost of parts can be reduced.

In the exemplary embodiment, the variable capacitance element 4 of the matching circuit is a varactor diode, and the tuning voltage Vt, which is a reverse voltage, is applied to the variable capacitance element 4 to change the capacitance value thereof. Thus, the capacitance value of the variable capacitance element 4 can easily be controlled. In addition, the tuning voltage Vt is applied to the variable capacitance element 4 via the transmission line 10 transmitting a high-frequency signal. Thus, wiring is simplified.

In the foregoing exemplary embodiment, electronic elements including electronic elements that form a matching circuit are provided on the upper surface of the base member 2 of the antenna device 1. Those electronic elements may be provided on a side surface or the like of the base member 2. Furthermore, any circuit other than a matching circuit, such as a low-noise amplifier circuit or a television tuner circuit may be provided on a surface of the base member 2.

## Claims

1. An antenna device comprising:
an antenna element; and
a matching circuit,
wherein a feed signal is supplied to the antenna element via the matching circuit,
the matching circuit including
a variable capacitance element,
a first inductance element connected in parallel to the variable capacitance element, and
a second inductance element connected in series with the variable capacitance element,
wherein a capacitance value of the variable capacitance element is changed to change a resonant frequency of the antenna element,
wherein the variable capacitance element and the first inductance element form a parallel circuit and a resonance point of the parallel circuit is set to a frequency lower than the resonant frequency, and
wherein as the resonant frequency increases, the resonance point is shifted to a high-frequency side.

2. The antenna device according to Claim 1, wherein the antenna element includes a dielectric or magnetic base member, and a radiating conductor provided on a surface of the base member.

3. The antenna device according to Claim 1 or 2, wherein the variable capacitance element comprises a varactor diode, and
wherein a tuning voltage is applied to the variable capacitance element via a transmission line transmitting a high-frequency signal.

4. The antenna device according to one of Claims 1-3, wherein the antenna device receives a terrestrial digital television broadcast signal wave.

5. The antenna device according to Claim 2, wherein the base member is cylindrical,
wherein the matching circuit and the radiating conductor are provided on the surface of the base member so that the radiating conductor is spirally wound around the surface of the base member, and
wherein the radiating conductor has a first end which serves as a feed portion, and a second end which is an open end.
